# EUROPEAN PATENT APPLICATION

(11) **EP 1 553 618 A1**
(43) Date of publication of application: **13.07.2005**
(21) Application number: 03751458.5
(22) Date of filing: 10.10.2003
(51) Int. Cl.: H01L 21/28

(54) **PRODUCTION METHOD FOR THIN-FILM CRYSTAL WAFER, SEMICONDUCTOR DEVICE USING IT AND PRODUCTION METHOD THEREFOR**

(30) Priority: 15.10.2002 JP 2002301059
(71) Applicant: Sumitomo Chemical Company, Limited, Tokyo 104-8260 (JP)
(72) Inventor: HATA, Masahiko, Tsuchiura-shi, Ibaraki 300-0845 (JP)
(74) Representative: Nicholls, Michael John
(86) International application number: PCT/JP2003/013067
(87) International publication number: WO 2004/036635

(57) **Abstract**

The n⁺-GaAs layer 8 of the GaAs single crystal 10 is formed by epitaxial growth, followed by epitaxially growing the Si-layer 11 in the same epitaxial growth furnace, and then the aluminum electrode 12 is formed on the Si-layer 11 as an ohmic electrode. The Si-layer 11 can suppress the formation of a surface defect level on the surface of the n⁺-GaAs layer 8 and can effectively prevent the formation of an unnecessary potential barrier. Since the Si-layer 11 has a smooth surface and is excellent in chemical stability, a good ohmic electrode can be obtained by forming the electrode 12 using aluminum or the like that has a suitable work function to the Si-layer 11.

## Description

### TECHNICAL FIELD

The present invention relates to a method for producing semiconductor wafers excellent in surface stability, and to semiconductor devices with good ohmic electrode properties using the same and a method for producing the semiconductor devices.

### BACKGROUND ART

III - V group compound semiconductor crystals such as GaAs, GaP and GaN are widely used for the production of semiconductor devices such as high-speed electron devices used in a high-frequency region of microwave bands or higher, or light-emitting devices such as various light-emitting diodes. When the compound semiconductor crystals as described above are used to produce semiconductor devices, electrical properties of the semiconductor crystal itself is naturally important. However, from the viewpoint of device applications, electrical properties of the electrode part for electrically connecting the semiconductor crystal to external devices are also important. In other words, formation of electrodes that can obtain ohmic connection capable of efficiently flowing current between the same and external devices has become an important technical problem.

Generally, the conduction band level or valence band level in semiconductors is often different from the work function of electrode metals. Therefore, in order to flow current into a semiconductor crystal through electrodes smoothly, it is necessary to select an electrode material that has a work function compatible with the band structure of a target semiconductor layer.

However, even when the electrode material to be mounted on a semiconductor crystal is selected from the viewpoint as described above, there is a problem that instability at the surface of the semiconductor crystal causes a potential barrier to form, and that the barrier inhibits a smooth flow of current. For example, in the case of a GaAs compound semiconductor, a high-density surface defect level is spontaneously formed; the Fermi level is fixed near the surface defect level; and the surface defect level is formed in a forbidden band. Consequently, a depletion layer that becomes a potential barrier is often formed near the surface. This means that a certain depletion layer forms whichever electrode metal is used. Therefore, the depletion layer makes it practically difficult to obtain ideal ohmic properties even if an electrode material is suitably selected.

In order to address this problem, the following configurations have been devised and are well known: a configuration in which a crystal layer such as InGaAs, which has a small forbidden band width and a small potential barrier, is formed between a semiconductor crystal and an electrode as an electrode connecting layer to reduce the energy gap between the electrode and the semiconductor crystal; or a configuration in which an abundance of impurities are added so that the thickness of a depletion layer is reduced to the extent that the current from an electrode smoothly flows to a semiconductor crystal by the tunnel effect, by using the fact that the thickness of a depletion layer is reduced by increasing the concentration of impurities.

However, when an InGaAs layer is provided as an electrode connecting layer, the InGaAs layer or the like is formed on a GaAs layer which is formed on the top layer of a semiconductor crystal, wherein the InGaAs layer has a different lattice constant from that of the GaAs layer. Consequently, undue compression or tensile stress acts on the inside of a finished semiconductor device. This causes distortion to form or surface morphology to deteriorate, in turn causing a break in a wire or other problems to a fine patterning. On the other hand, when the thickness of a depletion layer which forms a potential barrier is reduced by adding a large amount of impurities, thermal stability of a semiconductor will be impaired, resulting in instability of the operation of a finished semiconductor device and reduction in reliability of the operation thereof.

### DISCLOSURE OF THE INVENTION

An object of the present invention is to provide a method for producing semiconductor wafers excellent in surface stability, and to provide semiconductor devices with good ohmic electrode properties using the same and a method for producing the semiconductor devices, whereby the above described problems in conventional technology can be solved.

In order to solve the above described problems, the present invention has made it possible to obtain a semiconductor laminate structure excellent in surface stability and having good ohmic electrode properties by laminating a Si-layer with an appropriate crystal structure on a III-V group compound semiconductor single crystal such as GaAs.

The present invention is described as follows:
(1) A semiconductor device using a III-V group compound semiconductor single crystal comprising a doped III-V group compound semiconductor single crystal epitaxial layer, a Si-layer formed on the above described III-V group compound semiconductor single crystal epitaxial layer, and a metal electrode formed on the above described Si-layer as an ohmic electrode.
(2) The semiconductor device according to the above (1), wherein the above described III-V group compound semiconductor single crystal epitaxial layer is n-type doped, and the above described metal electrode is an ohmic electrode for electrons.
(3) The semiconductor device according to the above (1), wherein the above described III-V group compound semiconductor single crystal epitaxial layer is p-type doped, and the above described metal electrode is an ohmic electrode for holes.
(4) The semiconductor device according to any of the above (1) to (3), wherein the above described III-V group compound semiconductor single crystal is a single crystal composed of any one selected from the group consisting of GaAs, InGaAs and InP.
(5) The semiconductor device according to any of the above (1) to (4), wherein the above described Si-layer is a single crystal layer epitaxially grown on the above described III-V group compound semiconductor single crystal epitaxial layer.
(6) The semiconductor device according to any of the above (1) to (4), wherein the above described Si-layer is formed on the above described III-V group compound semiconductor single crystal epitaxial layer as a polycrystalline layer or an amorphous layer.
(7) The semiconductor device according to any of the above (1) to (6), wherein the above described metal electrode comprises aluminum.
(8) A method for producing a thin film,crystal wafer for a III-V group compound semiconductor device, comprising the steps of:
   laminating required compound semiconductor thin film crystal layers on a semiconductor substrate by epitaxial growth to obtain a III-V group compound semiconductor single crystal; and
   forming a Si-layer on the above described III-V group compound semiconductor single crystal by epitaxial growth,
   wherein the above described steps are performed in a same epitaxial growth furnace.
(9) The method according to the above (8),
   wherein the above described epitaxial growth is performed by a metal organic vapor phase epitaxy method (MOVPE method) or a molecular beam epitaxy method (MBE method).
(10) The method according to the above (8),
   wherein the above described III-V group compound semiconductor single crystal is a GaAs single crystal.
(11) The method according to the above (8),
   wherein, when the above described Si-layer is formed, a thin film layer of the above described III-V group compound semiconductor single crystal to be joined to the above described Si-layer is n-type doped with Si.
(12) The method according to the above (8),
   wherein the above described semiconductor single crystal contains As, and, when the above described Si-layer is formed, the above described Si-layer is n-type doped with As in a thin film crystal layer of the above described III-V group compound semiconductor single crystal to be joined to the above described Si-layer.
(13) The method according to any of the above (8) to (12), wherein the above described Si-layer is formed as a single crystal layer, a polycrystalline layer or an amorphous layer.
(14) A method for producing a semiconductor device using a III-V group compound semiconductor single crystal, comprising the steps of:
   laminating required compound semiconductor thin film crystal layers on a semiconductor substrate by epitaxial growth to obtain a III-V group compound semiconductor single crystal;
   forming a Si-layer on the above described III-V group compound semiconductor single crystal by epitaxial growth,
wherein the above described steps are performed in a same epitaxial growth furnace; and then
forming a metal electrode acting as an ohmic electrode on the above described Si-layer.

By forming a Si-layer on a III-V group compound semiconductor single crystal epitaxial layer, it is possible to suppress the formation of a surface defect level on the surface of the III-V group compound semiconductor single crystal epitaxial layer and to effectively prevent an unnecessary potential barrier to be formed. Since the Si-layer has a smooth surface and is excellent in chemical stability, it is possible to obtain a good ohmic electrode by forming an electrode using a metal having a suitable work function to the Si-layer, for example, aluminum or the like.

### BRIEF DESCRIPTION OF THE DRAWINGS

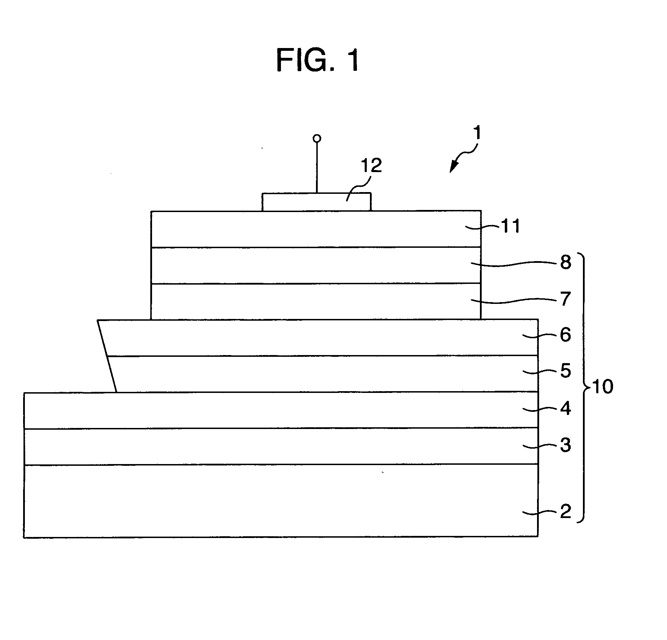

Fig. 1 is a sectional view showing an exemplary embodiment of a semiconductor device according to the present invention.

### BEST MODE FOR CARRYING OUT THE INVENTION

An exemplary embodiment of the present invention will now be described in detail with reference to the drawing.

Fig. 1 shows an exemplary embodiment of a semiconductor device according to the present invention in a sectional view. The semiconductor device shown in Fig. 1 is a hetero-junction bipolar transistor (HBT) 1 that is built using a III-V group compound semiconductor crystal. HBT 1 is built using a GaAs single crystal 10, which is a III-V group compound semiconductor single crystal for HBT having a known configuration, and by which it functions as an HBT device. The GaAs single crystal 10 is manufactured by successively laminating, on a GaAs substrate 2, a buffer layer 3, an n⁺-GaAs layer (conductive layer) 4, an n-GaAs layer (collector layer) 5, a p-GaAs layer (base layer) 6, an n-InGaP layer (emitter layer) 7, an n⁺-GaAs layer (emitter cap layer) 8, in an appropriate epitaxial growth furnace, by an appropriate epitaxial growth method such as a metal organic vapor phase epitaxy method (MOVPE method) or a molecular beam epitaxy method (MBE method).

The n⁺-GaAs layer 8 which is the top layer of the GaAs single crystal 10 is an n-type doped GaAs layer, which corresponds to an (n-type) "doped III-V group compound semiconductor single crystal epitaxial layer" in the present invention. The Si-layer 11 is formed by lamination on the n⁺-GaAs layer 8 for providing an emitter electrode as an ohmic electrode above the n⁺-GaAs layer 8. The electrode layer 12 composed of aluminum (Al) is formed on the Si-layer 11 as the ohmic electrode for electrons.

Formation of the Si-layer 11 by lamination on the n⁺-GaAs layer 8 that is chemically unstable and is apt to form a surface defect level can effectively prevent a potential barrier such as a depletion layer from forming in the n⁺-GaAs layer 8. Moreover, formation on the Si-layer 11 of the aluminum electrode 12 that can obtain a good ohmic connection to Si establishes a good ohmic connection between the electrode 12 and the n-InGaP layer (emitter layer).

Generally, GaAs crystals are rapidly oxidized in air, and a depletion layer formed by the disorder of the crystal surface at the oxidation allows a high-density surface level to form, which prevents the formation of a good ohmic electrode. Therefore, it is possible to form a Si/GaAs hetero-junction without allowing the unstable surface level to form, by growing the n⁺-GaAs layer 8 in an epitaxial growth furnace followed by epitaxially growing the Si-layer 11 in the same epitaxial growth furnace by the MOVPE method, the MBE method or the like.

Specifically, preferably, on the GaAs substrate 2, the buffer layer 3 through the n⁺-GaAs layer (emitter cap layer) 8 are successively formed by lamination in an appropriate epitaxial growth furnace by an appropriate epitaxial growth method such as the MOVPE method, the MBE method or the like to form the GaAs single crystal 10, and subsequently a Si raw material such as silane (SiH₄) or disilane (Si₂H₆) is supplied to the same epitaxial growth furnace and thermally decomposed by the above described appropriate epitaxial growth method, the resulting Si being grown on the n⁺-GaAs layer 8 to form the Si-layer 11. Here, the Si-layer 11 is preferably formed as a single crystal layer that is epitaxially grown on the n⁺-GaAs layer 8, a GaAs crystal. However, the Si-layer 11 is not limited to be formed as a single crystal layer, but may be formed in a polycrystalline or amorphous form.

Here, the Si-layer 11 is preferably n-type doped with As, P or the like in order to make the ohmic connection more effective, in consideration of the Fermi level that is fixed near the surface defect level. Moreover, the Si-layer 11 desirably, but not critically, has a thickness in the range from several tens angstroms to several hundreds angstroms. For similar reasons, it is desirable that the n⁺-GaAs layer 8 be subjected to the n-type doping.

Although there is a little difference of the energy level at the end of a conduction band between GaAs and Si, the difference is so small that the junction resistance thereof can be made negligibly small by performing n-type doping of the Si-layer 11 and the n⁺-GaAs layer 8 as described above. The n-type doping can be performed for the n⁺-GaAs layer 8 and the Si-layer 11 using a suitable means for each layer. However, without performing an intentional doping, mutual diffusion by heating between the n⁺-GaAs layer 8 and the Si-layer 11, when the Si-layer 11 is formed on the n⁺-GaAs layer 8, allows the amount of doping with a sufficient concentration in each layer to be achieved.

Since the Si-layer 11 has a very stable surface and a small surface level, a good ohmic connection can be achieved between the Si-layer 11 and the electrode 12 by using aluminum that is a metal having a suitable electron affinity, in the manner similar to the Si semiconductor technology. As a result, the GaAs single crystal 10 can be electrically connected to external devices through the electrode 12 to achieve a good ohmic connection of the both.

The configuration of an emitter electrode was described in the above described embodiment, but a good ohmic electrode can be provided similarly in the cases of a base electrode to a base layer and a collector electrode to a collector layer. Moreover, the semiconductor device according to the present invention is not limited to HBT devices, but as a matter of course, it may be widely applied to light-emitting diode devices, HEMT devices and the like.

The above described embodiment described the case in which the III-V group compound semiconductor single crystal epitaxial layer is n-type doped and the metal electrode is the ohmic electrode for electrons.

On the other hand, the present invention can be similarly applied to the case in which a III-V group compound semiconductor single crystal epitaxial layer is p-type doped and a metal electrode is the ohmic electrode for holes, and thereby similar effect can be obtained.

### INDUSTRIAL APPLICABILITY

According to the present invention, it is possible to effectively prevent an unnecessary potential barrier to be formed and to form a good ohmic connection between a Si-layer and an electrode by forming a Si-layer on a III-V group compound semiconductor single crystal epitaxial layer. As a result, it is possible to efficiently flow current between the III-V group compound semiconductor single crystal and external devices through the electrode.

## Claims

1. A semiconductor device using a III-V group compound semiconductor single crystal comprising:
a doped III-V group compound semiconductor single crystal epitaxial layer;
a Si-layer formed on said III-V group compound semiconductor single crystal epitaxial layer; and
a metal electrode formed on said Si-layer as an ohmic electrode.

2. The semiconductor device according to claim 1, wherein said III-V group compound semiconductor single crystal epitaxial layer is n-type doped, and said metal electrode is an ohmic electrode for electrons.

3. The semiconductor device according to claim 1, wherein said III-V group compound semiconductor single crystal epitaxial layer is p-type doped, and said metal electrode is an ohmic electrode for holes.

4. The semiconductor device according to any one of claims 1 to 3, wherein said III-V group compound semiconductor single crystal is a single crystal composed of any one selected from the group consisting of GaAs, InGaAs and InP.

5. The semiconductor device according to any one of claims 1 to 4, wherein said Si-layer is a single crystal layer epitaxially grown on said III-V group compound semiconductor single crystal epitaxial layer.

6. The semiconductor device according to any one of claims 1 to 4, wherein said Si-layer is formed on said III-V group compound semiconductor single crystal epitaxial layer as a polycrystalline layer or an amorphous layer.

7. The semiconductor device according to any one of claims 1 to 6, wherein said metal electrode comprises aluminum.

8. A method for producing a thin film crystal wafer for a III-V group compound semiconductor device, comprising the steps of:
laminating required compound semiconductor thin film crystal layers on a semiconductor substrate by epitaxial growth to obtain a III-V group compound semiconductor single crystal; and
forming a Si-layer on said III-V group compound semiconductor single crystal by epitaxial growth,
wherein said steps are performed in a same epitaxial growth furnace.

9. The method according to claim 8, wherein said epitaxial growth is performed by a metal organic vapor phase epitaxy method (MOVPE method) or a molecular beam epitaxy method (MBE method).

10. The method according to claim 8, wherein said III-V group compound semiconductor single crystal is a GaAs single crystal.

11. The method according to claim 8, wherein, when said Si-layer is formed, a thin film layer of said III-V group compound semiconductor single crystal to be joined to said Si-layer is n-type doped with Si.

12. The method according to claim 8, wherein a thin film layer of said compound semiconductor single crystal contains As, and, when said Si-layer is formed, said Si-layer is n-type doped with As in a thin film crystal layer of said III-V group compound semiconductor single crystal to be joined to said Si-layer.

13. The method according to any one of claims 8 to 12, wherein said Si-layer is formed as a single crystal layer, a polycrystalline layer or an amorphous layer.

14. A method for producing a semiconductor device using a III-V group compound semiconductor single crystal, comprising the steps of:
laminating required compound semiconductor thin film crystal layers on a semiconductor substrate by epitaxial growth to obtain a III-V group compound semiconductor single crystal;
forming a Si-layer on said III-V group compound semiconductor single crystal by epitaxial growth,
wherein said steps are performed in a same epitaxial growth furnace; and then
forming a metal electrode acting as an ohmic electrode on said Si-layer.
